# EUROPEAN PATENT SPECIFICATION

(11) **EP 2 857 848 B1**
(45) Date of publication and mention of the grant of the patent: **29.08.2018**
(21) Application number: 13004745.9
(22) Date of filing: 01.10.2013
(51) Int. Cl.: G01R 15/06, G01R 15/16

(54) **Capacitive voltage measuring apparatus.**
Kapazitive Spannungsmessvorrichtung
Appareil de mesure capacitatif de tension

(43) Date of publication of application: 08.04.2015
(73) Proprietor: Sécheron SA, 1242 Satigny (CH)
(72) Inventor: Tricarico, Claudio, 1260 Nyon (CH); Venzin, Nicolas, 74250 Fillinges (FR); Schaerrer, Marc, 1233 Bernex (CH)
(74) Representative: Micheli & Cie SA

(56) References cited:
- EP-A1- 0 134 541
- EP-A1- 0 980 003
- WO-A1-2009/153823
- WO-A1-2009/153824
- DE-A1- 19 855 528
- US-A- 4 700 123

## Description

### TECHNICAL FIELD OF THE INVENTION

The present invention relates to a capacitive-type measuring apparatus for measuring an alternating voltage between a first electrical potential and a second electrical potential. More particularly, the present invention relates to such an apparatus for measuring high alternating voltages, i.e. voltages above 1 kV, typically of 15 kV (at 16.7 Hz) or 25 kV (at 50 Hz). One preferred application of the present invention consists in measuring the voltage supplied by an overhead line to a railway vehicle for its propulsion.

### TECHNICAL BACKGROUND

A capacitive-type measuring apparatus uses one or more capacitors connected between the high potential and the low potential for measuring the voltage between these potentials. Typical capacitive measuring apparatuses act as voltage dividers comprising two capacitors in series between the two potentials, the voltage across one of the capacitors being measured to provide a measurement of the overall voltage across both capacitors. With respect to other kinds of measuring apparatuses such as transformers or resistive dividers, capacitive-type measuring apparatuses are generally considered to be safer.

One example of a capacitive-type measuring apparatus is disclosed in GB 741,392. In this apparatus two large and concave electrodes face one another and are separated by air. The upper concave electrode is connected to the high potential while the lower concave electrode is connected to ground. A metallic measuring probe projecting axially inside the lower concave electrode forms with the upper and lower concave electrodes a voltage divider. The concave shape of the electrodes shield the substantially axial operative electrical field from extraneous objects and electrical potentials or fields and make it unlikely to have electrical arcs appearing between the high potential and the measuring probe. However, to achieve good shielding the concave electrodes must have large dimensions, thus rendering the apparatus bulky. Moreover the distance between the upper concave electrode and the measuring probe is large and, as a result, the capacitive coupling and the signal-to-noise ratio are low.

GB 641,421 discloses another example of a capacitive-type measuring apparatus, comprising a chain of measuring capacitors forming a voltage divider and a chain of screening capacitors forming another voltage divider between the high potential and ground. Screening conductors connected to the chain of screening capacitors surround the measuring capacitors to reduce the effect of the stray capacitances between the measuring capacitors and earth. Further, the relative axial position of the two chains of capacitors is adjusted so as to eliminate the effect of the stray capacitance between them. This apparatus is complicated in the sense that it requires a voltage divider to drive the electric potential of the screening conductors.

US 4,700,123 discloses a capacitive-type measuring apparatus comprising, within an insulating medium, three coaxial and overlapping electrodes, namely a cylindrical high-voltage electrode which is closed at its upper end and open at its lower end, a cylindrical measuring electrode which is closed at its upper end and extends axially from the inside to the outside of the high-voltage electrode through the lower open end thereof, and a ground electrode which also extends axially from the inside to the outside of the high-voltage electrode and which surrounds part of the measuring electrode. The ground electrode and the measuring electrode are separated by an insulating material but are electrically connected across a voltage divider. The high-voltage electrode, ground electrode and measuring electrode form together a voltage divider, the output voltage being taken across the ground and measuring electrodes. This apparatus has the drawback that the electrical field in the vicinity of the lower open end of the high-voltage electrode and at the interface between air and the insulating medium may be locally high, thus creating a risk of electrical breakdown due to the low dielectric strength of air with respect to the insulating medium.

DE 19855528 discloses a capacitive voltage divider comprising, embedded in a resin, a primary voltage electrode, a measuring electrode connected to a measuring port and floating-potential field control electrodes. The primary voltage electrode is rod-shaped. The measuring electrode and the field control electrodes are tubular and surround the primary voltage electrode. A grounded metal shield shrouds the resin.

### SUMMARY OF THE INVENTION

The present invention aims at remedying, at least partly, the above-mentioned drawbacks and provides to this effect a capacitive-type measuring apparatus for measuring an alternating voltage between a first electrical potential and a second electrical potential, comprising:
- a first electrode arranged to be electrically connected to the first potential,
- a second electrode arranged to be electrically connected to the second potential,
- a space between the first and second electrodes,
- a third electrode disposed in or near said space and separate from the first and second electrodes, and
- a measuring electronic circuit electrically connected to the first and third electrodes,
characterised by further comprising a fourth electrode which is separate from the first, second and third electrodes, said fourth electrode having a floating potential and facing an opening of said space, said fourth electrode also surrounding a zone including the third electrode, at least part of the first electrode and at least part of the second electrode.

Preferably, the capacitive-type measuring apparatus further comprises an insulating medium having a greater dielectric strength than air at atmospheric pressure and in which the first, second, third and fourth electrodes are embedded.

Preferably, the first and second electrodes do not overlap.

The first, second, third and fourth electrodes may be coaxial.

The third electrode may have a flat shape.

At least part of each of the first and second electrodes may have a generally cylindrical shape.

The fourth electrode may have a generally tubular shape.

The second electrode may have a flat surface portion facing the third electrode.

Advantageously, the third electrode is located in a recess provided in a surface of the first electrode that faces the second electrode, and may be flush with a peripheral portion of said surface of the first electrode. The third electrode may be in the form of a conductive layer provided on an insulating plate mounted in said recess.

Preferably, the measuring electronic circuit is located within the first electrode.

The measuring electronic circuit may comprise a capacitor electrically connected between the first and third electrodes, and a device for measuring a voltage across said capacitor.

Alternatively, the measuring electronic circuit may comprise an operational amplifier arranged to act as an integrator, a first input of the operational amplifier being electrically connected to the third electrode, a second input of the operational amplifier being electrically connected to the first electrode, and a device for measuring a voltage at an output of the operational amplifier.

The present invention also proposes to use a capacitive-type measuring apparatus as defined above for measuring an alternating voltage supplied to a railway vehicle.

### BRIEF DESCRIPTION OF THE DRAWINGS:

Other features and advantages of the present invention will be apparent upon reading the following detailed description made with reference to the appended diagrammatic drawings in which:
- Figure 1 shows in cross-section a capacitive-type measuring apparatus according to the invention;
- Figure 2 shows an electronic circuit used in the capacitive-type measuring apparatus according to the invention;
- Figure 3 shows part of the said electronic circuit, according to a variant of the invention; and
- Figure 4 shows in cross-section a variant of the capacitive-type measuring apparatus according to the invention.

### DETAILED DESCRIPTION

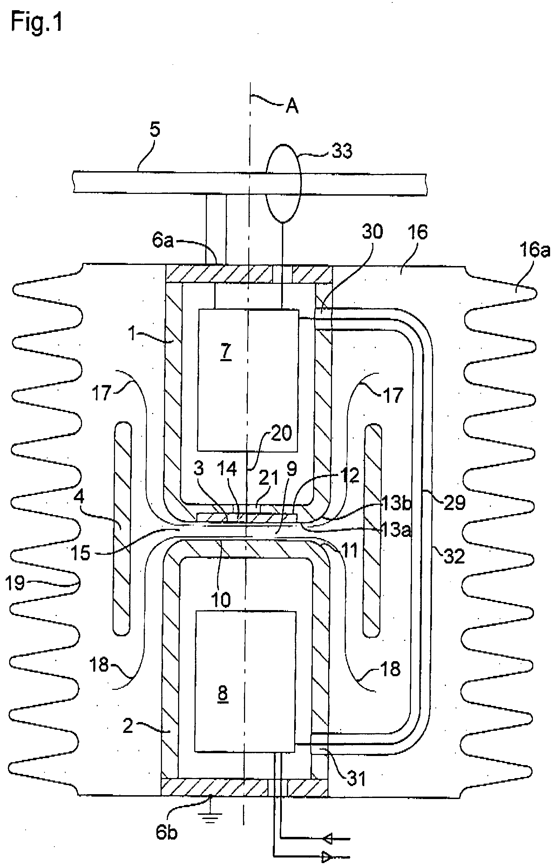

Referring to Figure 1, a capacitive-type electrical measuring apparatus according to the present invention comprises four electrodes 1 to 4.

The first electrode 1 is electrically connected to a high potential to be measured, supplied by a high-voltage electrical line 5. The point of contact between the first electrode 1 and the high-voltage electrical line 5 is designated by reference numeral 6a. The second electrode 2 is electrically connected to a low potential, typically but not exclusively the ground (earth) potential. The point of contact between the second electrode 2 and the source of low potential is designated by reference numeral 6b. The first and second electrodes 1, 2 have generally cylindrical shapes extending along a common axis A, with preferably substantially identical diameters, are hollow to receive electronic circuits 7, 8 and are separated by a space 9. The external surface 10 of the second electrode 2 that faces the first electrode 1 is flat and perpendicular to the axis A except for its edge 11 which is rounded to avoid creating a strong local electrical field. The external surface of the first electrode 1 that faces the second electrode 2 defines in its central portion a recess 12 having a flat bottom perpendicular to the axis A. Radially beyond the recess 12 the said external surface of the first electrode 1 has a peripheral flat surface portion 13a terminating in a rounded edge 13b.

The third electrode 3 is provided in the space 9 between the first and second electrodes 1, 2, and more precisely in the recess 12 of the first electrode 1. In the example shown, the third electrode 3 is in the form of a conductive layer deposited on a disc-shaped insulating plate 14 mounted (e.g. bonded) in the recess 12 against the flat bottom thereof so as to be coaxial with the first and second electrodes 1, 2. The thicknesses of the recess 12, insulating plate 14 and third electrode 3 are preferably such that the third electrode 3 is flush with the peripheral surface portion 13a. The third electrode 3 however does not contact the first electrode 1. This arrangement of the first, second and third electrodes 1, 2, 3 enables the electrical field to be substantially uniform in the space 9 and particularly in the space between the second and third electrodes 2, 3. Since it is close to the third electrode 3 and has a larger diameter than this latter, the first electrode 1 shields the third electrode 3. Arranging the third electrode 3 so that it is flush with the peripheral surface portion 13a gives the equipotentials a continuous and smooth shape in the space 9 and avoids the need for the electrode 3 to have rounded edges. The second and third electrodes 2, 3 together form a first measuring capacitor.

The insulating plate 14 may have an internal conductive layer or may be covered with a conductive layer at its side opposite to the side supporting the third electrode 3. Such a conductive layer is conductively connected to the first electrode 1, e.g. by means of an electrical wire, to have the same potential as the first electrode 1. Such a conductive layer shields the electronic circuit 7 and the electrical field generated by the first, second and third electrodes 1, 2, 3 from one another.

The fourth electrode 4 is in the form of a tube coaxial with the first, second and third electrodes 1, 2, 3. The fourth electrode 4 faces and surrounds a circular peripheral opening 15 of the space 9, i.e. the opening through which the equipotentials starting between the first, second and third electrodes 1, 2, 3 pass and extend away from the first, second and third electrodes 1, 2, 3. More precisely, the fourth electrode 4 overlaps the first and second electrodes 1, 2 and surrounds a zone including the third electrode 3, part of the first electrode 1 and part of the second electrode 2.

The electrodes 1 to 4 are each made of a conductive material, typically a metal such as aluminium for the electrodes 1, 2, 4 or copper for the electrode 3. The electrodes 1 to 4 are embedded in, and thus mutually separated by, an insulating (dielectric) medium or material 16 which is other than air at atmospheric pressure. The insulating medium 16 is preferably a solid material such as an epoxy resin, e.g. an epoxy resin charged with silica, moulded over the electrodes 1 to 4. The insulating plate 14 may also be made of an epoxy resin, such as an epoxy resin filled with glass fibres. Such epoxy resin materials have a dielectric constant that is stable in temperature, frequency and time. Since the dielectric strength of the insulating medium 16 and of the insulating plate 14 is greater than the dielectric strength of air at atmospheric pressure, the gaps between the electrodes 1 to 4 may be reduced and, as a result, a more compact apparatus may be obtained. Moreover the insulating medium 16 is homogeneous and thus avoids the interface weak points which appear frequently in other types of electrical measuring apparatus such as resistive dividers and which create a risk of electrical breakdown.

In a variant the insulating medium 16 is in the form of a gel, liquid or gas contained in a solid tube forming the external envelope of the apparatus. The solid tube may be made of a glass-reinforced composite or porcelain, for example. The insulating medium filling the solid tube may be silicone, polyurethane, oil, a gas such as SF6, air under pressure or vacuum. In such a variant, the fourth electrode 4 may have a rib that engages a groove in the inner wall of the solid tube to hold the fourth electrode 4.

The apparatus according to the invention advantageously takes the shape of an insulator that may also have sheds 16a at its periphery as a protection against the effect of rain and humidity, as is already known. The sheds 16a may be an integral part of the insulating medium 16 or may be added in a second manufacturing step and made from the same or a different material.

The electric potential of the fourth electrode 4 is floating. In other words the fourth electrode 4 is electrically connected to neither the first, second or third electrode 1, 2, 3 nor any other object. Concretely, the fourth electrode 4 is fully surrounded by the insulating medium 16 and its potential is determined only by the stray capacitances between it and the neighbouring objects. The electrical field in the space 9 is determined by the potentials of the first, second, third and fourth electrodes 1, 2, 3, 4 and only very marginally by the potentials of objects outside the insulating medium 16, making the charges flowing into the third electrode 3 completely proportional to the derivative of the voltage to measure and completely immune to exterior perturbations. The objects that mainly influence the potential of the fourth electrode 4 are the first and second electrodes 1, 2. The first, second and fourth electrodes 1, 2, 4 may thus be dimensioned so that the potential of the fourth electrode 4 is at a desired value between the potentials of the first and second electrodes 1, 2, e.g. the average of the potentials of the first and second electrodes 1, 2. In this manner, the fourth electrode 4 not only shields the operative electrical field in the space 9 from the influence of extraneous objects which could disturb the measurement, but also homogenises the electrical field outside the apparatus. Indeed, the equipotentials of the electrical field generated by the electrodes 1, 2, 3 that pass through the opening 15 are divided into two groups, namely a first group (represented by line 17 in Figure 1) passing through one end of the fourth electrode 4 (on the first electrode 1 side) and a second group (represented by line 18 in Figure 1) passing through the other end of the fourth electrode 4 (on the second electrode 2 side). This arrangement avoids a strong local field being formed at the interface 19 between the insulating medium 16 and air, which could cause electrical breakdowns outside the apparatus due to the fact that air has a lower dielectric strength. This arrangement allows the use of a thin layer of insulating medium around the fourth electrode 4 and therefore a compact and lightweight apparatus. Moreover, since the fourth electrode 4 is not electrically connected to any conductor, the design and manufacturing of the apparatus are facilitated.

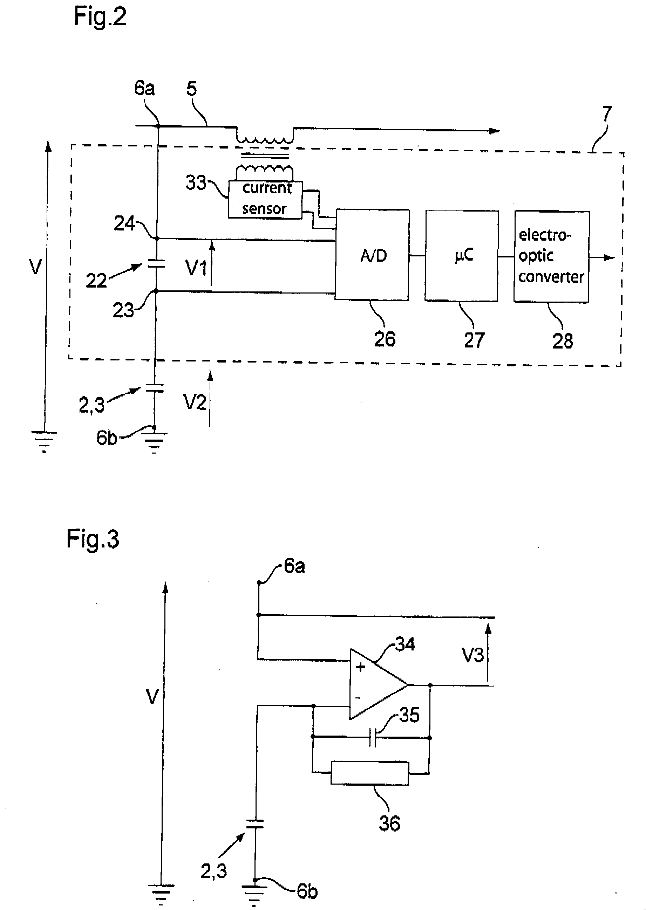

Figure 2 shows how the voltage (or potential difference) V between the contact points 6a, 6b (or in other words between the first and second electrodes 1, 2) is measured. An electrical conductor 20 crossing an opening 21 of the flat bottom of the recess 12 connects the third electrode 3 to a first terminal 23 of a second measuring capacitor 22 in the electronic circuit 7, the second terminal 24 of the second measuring capacitor 22 being connected to the contact point 6a, i.e. to the potential of the first electrode 1. The first measuring capacitor 2, 3 and the second measuring capacitor 22 form together a capacitive voltage divider between the potentials of the first and second electrodes 1, 2. The capacitance of the second measuring capacitor 22 is selected so as to be much greater than the capacitance of the first measuring capacitor 2, 3. The voltage V1 across the second measuring capacitor 22 is therefore much lower than the voltage V2 across the first measuring capacitor 2, 3. In the electronic circuit 7, an analog-to-digital converter 26 measures and digitizes the voltage V1 and a microcontroller 27 processes the digitized voltage to provide a digital value of the high voltage V between the contact points 6a and 6b based on the known capacitances of the first measuring capacitor 2, 3 and of the second measuring capacitor 22. The microcontroller 27 supplies an encoded signal including the said digital value of the high voltage V to an electro-optical converter 28 for its transmission to the electronic circuit 8 in the second electrode 2 via an optical fibre 29. The optical fibre 29 (see Figure 1) interconnects the electronic circuits 7, 8 by passing though openings 30, 31 of the first and second electrodes 1, 2 and through a tunnel 32 formed in the insulating medium 16. The electronic circuit 8 includes an electro-optical converter (not shown) for converting the received optical signal into an electrical signal, a microcontroller (not shown) for decoding the converted electrical signal and a customer interface (not shown) enabling the value of the high voltage V to be retrieved by an operator. Both electronic circuits 7, 8 may further include correction, compensation and filtering means. The electronic circuit 8 may also be placed outside the second electrode 2. The transmission of data between the electronic circuits 7, 8 needs to be isolated but may also be made by other means than an optical fibre, for example by infrared, direct optical link or radio transmission.

In addition to measuring the high voltage V, the electronic circuit 7 may measure the current flowing in the high-voltage electrical line 5. To this end the electronic circuit 7 may comprise a current sensor 33, for example a shunt, an inductive transformer, a Rogowsky coil or any other type of passive or active current sensor. A digitized value of the measured current is then included into the encoded signal transmitted by the optical fibre 29 to be retrievable from the customer interface of the electronic circuit 8. The microcontroller 27 may also calculate, based on the synchronously measured high voltage and current, the power and energy supplied by the high-voltage electrical line 5 and include a value thereof into the encoded signal transmitted by the optical fibre 29. A measured temperature and other signals may also be transmitted from the electronic circuit 7 to the electronic circuit 8.

Figure 3 shows an alternative mode of measurement of the high voltage V. In the example of Figure 3 the third electrode 3 is electrically connected to the negative input of an operational amplifier 34, the positive input of the operational amplifier 34 being connected to the contact point 6a, i.e. to the high potential to be measured. The operational amplifier 34 acts as an integrator. To this effect a feedback loop comprising a capacitor 35 and a resistor 36 in parallel is connected between the output and the negative input of the operational amplifier 34. Such an operational amplifier modifies its output so that its positive and negative inputs have the same potential and, like the capacitor 22 in Figure 2, the capacitor 35 integrates the current flowing through the measuring capacitor 2, 3. The voltage V3 between the positive input and the output of the operational amplifier 34 is proportional to the voltage V to be measured. The voltage V3 is thus measured, digitized and processed by the units 26, 27 to supply a corresponding value of the voltage V to the electronic circuit 8 via the optical fibre 29. With respect to the measurement mode shown in Figure 2 the alternative of Figure 3 has the advantage of being less sensitive to stray resistances and capacitances due to the voltage between the third electrode 3 and the first electrode 1 being substantially zero. In the embodiment of Figure 2 the measuring capacitor 2, 3 withstands the major part of the high voltage V to be measured. In the embodiment of Figure 3, on the other hand, the voltage across the measuring capacitor 2, 3 is the high voltage V to be measured.

Other alternative modes of measurement of the high voltage V may include means for measuring the current flowing from/into the third electrode 3 and means for integrating the measured current digitally.

Arranging the electronic circuits 7, 8 within the first and second electrodes 1, 2, as is shown in Figure 1, renders the overall apparatus more compact and protects the electronic circuits 7, 8 against external electromagnetic perturbations.

In an alternative embodiment of the invention the high and low potentials are reversed, i.e. the first electrode 1 is connected to the low potential (typically but not exclusively the ground potential) and the second electrode 2 is connected to the high potential to be measured. In this embodiment the electronic circuit that measures the high voltage, i.e. the electronic circuit in the first electrode 1, is in the low-voltage section of the apparatus and there is thus no need to transmit data from the high-voltage section to the low-voltage section of the apparatus. However, the embodiments shown in Figures 1 to 3 are advantageous in that they also allow current measurements without substantial isolation of the current sensor with respect to the high-voltage electrical line 5.

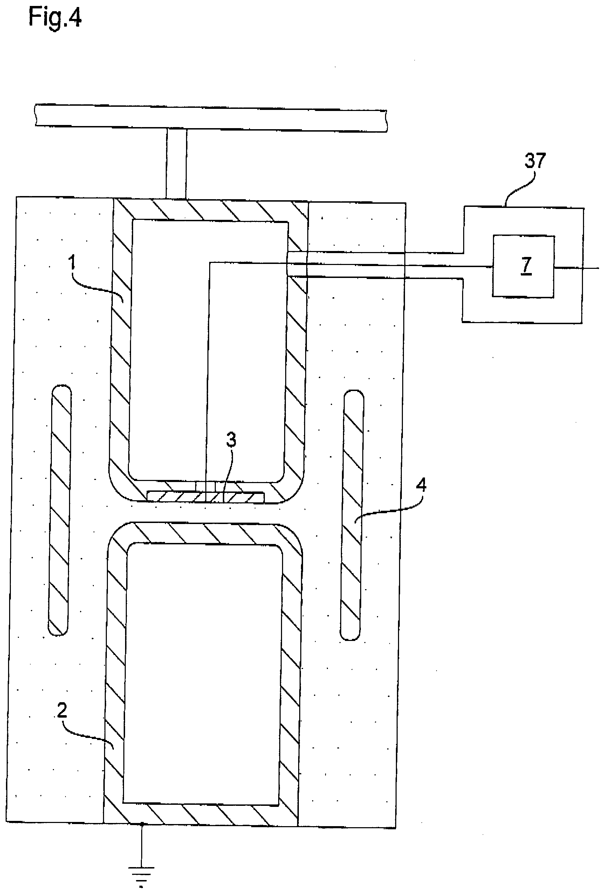

According to another embodiment of the invention, shown in Figure 4, the electronic circuit 7 that measures the high voltage is located outside the rest of the apparatus, in a conductive enclosure 37 which is electrically connected to the potential of the first electrode 1 and which communicates with the inside of the first electrode 1 to allow electrical connection between the third electrode 3 and the electronic circuit 7. Here also the potentials of the first and second electrodes 1, 2 may be reversed, i.e. the first electrode 1 may be connected to the low potential and the second electrode 2 may be connected to the high potential.

The apparatus according to the invention may be mounted on the roof or under the car body of a railway vehicle (typically a locomotive) to measure the high voltage supplied by the overhead line to the said vehicle for its propulsion. If the apparatus is also able to measure the current drawn from the overhead line, the energy supplied to the railway vehicle may be calculated for billing purposes.

The present invention has been described above by way of example only. It is clearly apparent to the skilled person that modifications may be made without departing from the scope of the claimed invention. In particular, the shape of the electrodes 1 to 4 could be different. For example, each of the first and second electrodes 1, 2 could be shaped to have a cylindrical portion near the space 9 and a smaller-diameter cylindrical portion in the vicinity of the contact point 6a, 6b. The fourth electrode 4 could have a conical shape or a tubular shape with a varying-thickness wall.

## Claims

1. Capacitive-type measuring apparatus for measuring an alternating voltage between a first electrical potential and a second electrical potential, comprising:
- a first electrode (1) arranged to be electrically connected to the first potential,
- a second electrode (2) arranged to be electrically connected to the second potential,
- a space (9) between the first and second electrodes (1, 2),
- a third electrode (3) disposed in or near said space (9) and separate from the first and second electrodes (1, 2), and
- a measuring electronic circuit (7) electrically connected to the first and third electrodes (1, 3),
**characterised by** further comprising a fourth electrode (4) which is separate from the first, second and third electrodes (1, 2, 3), said fourth electrode (4) having a floating potential and facing an opening (15) of said space (9), said fourth electrode (4) also surrounding a zone including the third electrode (3), at least part of the first electrode (1) and at least part of the second electrode (2).

2. Capacitive-type measuring apparatus according to claim 1, **characterised by** further comprising an insulating medium (16) having a greater dielectric strength than air at atmospheric pressure and in which the first, second, third and fourth electrodes (1-4) are embedded.

3. Capacitive-type measuring apparatus according to claim 1 or 2, **characterised in that** the first and second electrodes (1, 2) do not overlap.

4. Capacitive-type measuring apparatus according to any one of claims 1 to 3, **characterised in that** the first, second, third and fourth electrodes (1, 2, 3, 4) are coaxial.

5. Capacitive-type measuring apparatus according to any one of claims 1 to 4, **characterised in that** the third electrode (3) has a flat shape.

6. Capacitive-type measuring apparatus according to any one of claims 1 to 5, **characterised in that** at least part of each of the first and second electrodes (1, 2) has a generally cylindrical shape.

7. Capacitive-type measuring apparatus according to any one of claims 1 to 6, **characterised in that** the fourth electrode (4) has a generally tubular shape.

8. Capacitive-type measuring apparatus according to any one of claims 1 to 7, **characterised in that** the second electrode (2) has a flat surface portion (10) facing the third electrode (3).

9. Capacitive-type measuring apparatus according to any one of claims 1 to 8, **characterised in that** the third electrode (3) is located in a recess (12) provided in a surface of the first electrode (1) that faces the second electrode (2).

10. Capacitive-type measuring apparatus according to claim 9, **characterised in that** the third electrode (3) is flush with a peripheral portion (13a) of said surface of the first electrode (1).

11. Capacitive-type measuring apparatus according to claim 9 or 10, **characterised in that** the third electrode (3) is in the form of a conductive layer provided on an insulating plate (14) mounted in said recess (12).

12. Capacitive-type measuring apparatus according to any one of claims 1 to 11, **characterised in that** the measuring electronic circuit (7) is located within the first electrode (1).

13. Capacitive-type measuring apparatus according to any one of claims 1 to 12, **characterised in that** the measuring electronic circuit (7) comprises a capacitor (22) electrically connected between the first and third electrodes (1, 3), and a device (26) for measuring a voltage across said capacitor (22).

14. Capacitive-type measuring apparatus according to any one of claims 1 to 12, **characterised in that** the measuring electronic circuit (7) comprises an operational amplifier (34) arranged to act as an integrator, a first input of the operational amplifier (34) being electrically connected to the third electrode (3), a second input of the operational amplifier (34) being electrically connected to the first electrode (1), and a device for measuring a voltage at an output of the operational amplifier (34).

15. Use of a capacitive-type measuring apparatus according to any one of claims 1 to 14 for measuring an alternating voltage supplied to a railway vehicle.

## Patentansprüche

1. Messvorrichtung vom kapazitiven Typ zum Messen einer Wechselspannung zwischen einem ersten elektrischen Potential und einem zweiten elektrischen Potential, die Folgendes umfasst:
eine erste Elektrode (1), die so eingerichtet ist, dass sie mit dem ersten Potential elektrisch verbunden ist,
eine zweite Elektrode (2), die so eingerichtet ist, dass sie mit dem zweiten Potential elektrisch verbunden ist,
einen Zwischenraum (9) zwischen der ersten und der zweiten Elektrode (1, 2),
eine dritte Elektrode (3), die in dem Zwischenraum (9) oder in dessen Nähe angeordnet und von der ersten und der zweiten Elektrode (1, 2) getrennt ist, und
eine elektronische Messschaltung (7), die mit der ersten und der dritten Elektrode (1, 3) elektrisch verbunden ist,
**dadurch gekennzeichnet, dass** sie ferner eine vierte Elektrode (4) umfasst, die von der ersten, der zweiten und der dritten Elektrode (1, 2, 3) getrennt ist, wobei die vierte Elektrode (4) ein schwebendes Potential aufweist und einer Öffnung (15) des Zwischenraums (9) zugewandt ist, wobei die vierte Elektrode (4) auch eine Zone umgibt, zu der die dritte Elektrode (3), zumindest ein Teil der ersten Elektrode (1) und zumindest ein Teil der zweiten Elektrode (2) gehört.

2. Messvorrichtung vom kapazitiven Typ nach Anspruch 1, **dadurch gekennzeichnet, dass** sie ferner ein Isoliermittel (16) mit einer größeren Durchschlagsfestigkeit als Luft bei Atmosphärendruck umfasst, in dem die erste, die zweite, die dritte und die vierte Elektrode (1 bis 4) eingebettet sind.

3. Messvorrichtung vom kapazitiven Typ nach Anspruch 1 oder 2, **dadurch gekennzeichnet, dass** sich die erste und die zweite Elektrode (1, 2) nicht überlappen.

4. Messvorrichtung vom kapazitiven Typ nach einem der Ansprüche 1 bis 3, **dadurch gekennzeichnet, dass** die erste, die zweite, die dritte und die vierte Elektrode (1, 2, 3, 4) koaxial sind.

5. Messvorrichtung vom kapazitiven Typ nach einem der Ansprüche 1 bis 4, **dadurch gekennzeichnet, dass** die dritte Elektrode (3) eine flache Form aufweist.

6. Messvorrichtung vom kapazitiven Typ nach einem der Ansprüche 1 bis 5, **dadurch gekennzeichnet, dass** jeweils zumindest ein Teil der ersten und der zweiten Elektrode (1, 2) allgemein zylinderförmig ist.

7. Messvorrichtung vom kapazitiven Typ nach einem der Ansprüche 1 bis 6, **dadurch gekennzeichnet, dass** die vierte Elektrode (4) allgemein rohrförmig ist.

8. Messvorrichtung vom kapazitiven Typ nach einem der Ansprüche 1 bis 7, **dadurch gekennzeichnet, dass** die zweite Elektrode (2) einen flachen Oberflächenabschnitt (10) aufweist, der der dritten Elektrode (3) zugewandt ist.

9. Messvorrichtung vom kapazitiven Typ nach einem der Ansprüche 1 bis 8, **dadurch gekennzeichnet, dass** sich die dritte Elektrode (3) in einer Vertiefung (12) in einer Oberfläche der ersten Elektrode (1) befindet, die der zweiten Elektrode (2) zugewandt ist.

10. Messvorrichtung vom kapazitiven Typ nach Anspruch 9, **dadurch gekennzeichnet, dass** die dritte Elektrode (3) mit einem peripheren Abschnitt (13a) der Oberfläche der ersten Elektrode (1) bündig abschließt.

11. Messvorrichtung vom kapazitiven Typ nach Anspruch 9 oder 10, **dadurch gekennzeichnet, dass** die dritte Elektrode (3) in Form einer leitenden Schicht an einer Isolierplatte (14) vorliegt, die in der Vertiefung (12) angebracht ist.

12. Messvorrichtung vom kapazitiven Typ nach einem der Ansprüche 1 bis 11, **dadurch gekennzeichnet, dass** sich die elektronische Messschaltung (7) in der ersten Elektrode (1) befindet.

13. Messvorrichtung vom kapazitiven Typ nach einem der Ansprüche 1 bis 12, **dadurch gekennzeichnet, dass** die elektronische Messschaltung (7) einen Kondensator (22), der elektrisch zwischen die erste und die dritte Elektrode (1, 3) geschaltet ist, und eine Vorrichtung (26) zum Messen einer Spannung an dem Kondensator (22) umfasst.

14. Messvorrichtung vom kapazitiven Typ nach einem der Ansprüche 1 bis 12, **dadurch gekennzeichnet, dass** die elektronische Messschaltung (7) einen Operationsverstärker (34), der so eingerichtet ist, dass er als Integrierer dient, wobei ein erster Eingang des Operationsverstärkers (34) mit der dritten Elektrode (3) und ein zweiter Eingang des Operationsverstärkers (34) mit der ersten Elektrode (1) elektrisch verbunden ist, und eine Vorrichtung zum Messen einer Spannung an einem Ausgang des Operationsverstärkers (34) umfasst.

15. Verwendung einer Messvorrichtung vom kapazitiven Typ nach einem der Ansprüche 1 bis 14 zum Messen einer Wechselspannung, mit der ein Schienenfahrzeug gespeist wird.

## Revendications

1. Appareil de mesure de type capacitif pour mesurer une tension alternative entre un premier potentiel électrique et un second potentiel électrique, comprenant :
- une première électrode (1) agencée pour être connectée électriquement au premier potentiel,
- une deuxième électrode (2) agencée pour être connectée électriquement au second potentiel,
- un espace (9) entre les première et deuxième électrodes (1, 2),
- une troisième électrode (3) disposée dans ou à proximité dudit espace (9) et séparée des première et deuxième électrodes (1, 2), et
- un circuit électronique de mesure (7) connecté électriquement aux première et troisième électrodes (1, 3), **caractérisé en ce qu'**il comprend en outre une quatrième électrode (4) qui est séparée des première, deuxième et troisième électrodes (1, 2, 3), ladite quatrième électrode (4) ayant un potentiel flottant et faisant face à une ouverture (15) dudit espace (9), ladite quatrième électrode (4) entourant également une zone comprenant la troisième électrode (3), au moins une partie de la première électrode (1) et au moins une partie de la deuxième électrode (2).

2. Appareil de mesure de type capacitif selon la revendication 1, **caractérisé en ce qu'**il comprend en outre un milieu isolant (16) ayant une plus grande rigidité diélectrique que l'air à pression atmosphérique et dans lequel sont incorporées les première, deuxième, troisième et quatrième électrodes (1-4).

3. Appareil de mesure de type capacitif selon la revendication 1 ou 2, **caractérisé en ce que** les première et deuxième électrodes (1, 2) ne se chevauchent pas.

4. Appareil de mesure de type capacitif selon l'une quelconque des revendications 1 à 3, **caractérisé en ce que** les première, deuxième, troisième et quatrième électrodes (1, 2, 3, 4) sont coaxiales.

5. Appareil de mesure de type capacitif selon l'une quelconque des revendications 1 à 4, **caractérisé en ce que** la troisième électrode (3) a une forme plate.

6. Appareil de mesure de type capacitif selon l'une quelconque des revendications 1 à 5, **caractérisé en ce qu'**au moins une partie de chacune des première et deuxième électrodes (1, 2) a une forme généralement cylindrique.

7. Appareil de mesure de type capacitif selon l'une quelconque des revendications 1 à 6, **caractérisé en ce que** la quatrième électrode (4) a une forme généralement tubulaire.

8. Appareil de mesure de type capacitif selon l'une quelconque des revendications 1 à 7, **caractérisé en ce que** la deuxième électrode (2) présente une partie de surface plate (10) faisant face à la troisième électrode (3).

9. Appareil de mesure de type capacitif selon l'une quelconque des revendications 1 à 8, **caractérisé en ce que** la troisième électrode (3) est située dans un évidement (12) prévu dans une surface de la première électrode (1) faisant face à la deuxième électrode (2).

10. Appareil de mesure de type capacitif selon la revendication 9, **caractérisé en ce que** la troisième électrode (3) est affleurante à une partie périphérique (13a) de ladite surface de la première électrode (1).

11. Appareil de mesure de type capacitif selon la revendication 9 ou 10, **caractérisé en ce que** la troisième électrode (3) se présente sous la forme d'une couche conductrice agencée sur une plaque isolante (14) montée dans ledit évidement (12).

12. Appareil de mesure de type capacitif selon l'une quelconque des revendications 1 à 11, **caractérisé en ce que** le circuit électronique de mesure (7) est situé à l'intérieur de la première électrode (1).

13. Appareil de mesure de type capacitif selon l'une quelconque des revendications 1 à 12, **caractérisé en ce que** le circuit électronique de mesure (7) comprend un condensateur (22) connecté électriquement entre les première et troisième électrodes (1, 3), et un dispositif (26) pour mesurer une tension aux bornes dudit condensateur (22).

14. Appareil de mesure de type capacitif selon l'une quelconque des revendications 1 à 12, **caractérisé en ce que** le circuit électronique de mesure (7) comprend un amplificateur opérationnel (34) agencé pour agir en tant qu'intégrateur, une première entrée de l'amplificateur opérationnel (34) étant connectée électriquement à la troisième électrode (3), une seconde entrée de l'amplificateur opérationnel (34) étant connectée électriquement à la première électrode (1), et un dispositif pour mesurer une tension au niveau d'une sortie de l'amplificateur opérationnel (34).

15. Utilisation d'un appareil de mesure de type capacitif selon l'une quelconque des revendications 1 à 14 pour mesurer une tension alternative fournie à un véhicule ferroviaire.
